# EUROPEAN PATENT APPLICATION

(11) **EP 3 001 455 A1**
(43) Date of publication of application: **30.03.2016**
(21) Application number: 15158395.2
(22) Date of filing: 10.03.2015
(51) Int. Cl.: H01L 27/02, H02H 9/04

(54) **SEMICONDUCTOR DEVICE**

(30) Priority: 24.09.2014 JP 2014193831
(71) Applicant: Kabushiki Kaisha Toshiba, Tokyo 105-8001 (JP)
(72) Inventor: Fukuda, Shohei, 105-8001 Tokyo (JP)
(74) Representative: Hoffmann Eitle

(57) **Abstract**

According to one embodiment, a semiconductor device includes a first IO cell and a second IO cell arranged on a periphery of the core circuit. Each of the first IO cell and the second IO cell comprises: a power supply terminal to which a power supply voltage is applied; a ground terminal connected to ground; an RC delay circuit including a resistor having one terminal connected to one of the power supply terminal and the ground terminal and a capacitor having one terminal connected to the other terminal of the resistor and the other terminal connected to the other of the power supply terminal and the ground terminal; a P-type transistor; and an N-type transistor.

## Description

### FIELD

Embodiments described herein relate generally to a semiconductor device.

### BACKGROUND

As semiconductor devices micronize, ESD (Electro Static Discharge) of a circuit incorporated in a semiconductor device has raised a problem. There has been proposed an ESD protective element to protect the semiconductor device from such ESD.

### BRIEF DESCRIPTION OF THE DRAWING

FIG. 1 is a view showing the layout of a semiconductor device according to the first embodiment;
FIG. 2 is a view schematically showing a method of arranging an ESD protective element according to the first embodiment;
FIG. 3 is a sectional view showing an example of the IO cell or ESD protective element according to the first embodiment;
FIG. 4 is a block diagram showing a used IO cell according to the first embodiment;
FIG. 5 is a block diagram showing an ESD protective element according to the first embodiment;
FIG. 6 is a block diagram showing Modification 1 of the ESD protective element according to the first embodiment;
FIG. 7 is a block diagram showing Modification 2 of the ESD protective element according to the first embodiment;
FIG. 8 is a block diagram showing Modification 3 of the ESD protective element according to the first embodiment;
FIG. 9 is a block diagram showing Modification 4 of the ESD protective element according to the first embodiment;
FIG. 10 is a block diagram showing Modification 5 of the ESD protective element according to the first embodiment;
FIG. 11 is a view schematically showing a method of arranging an ESD protective element according to the second embodiment;
FIG. 12 is a block diagram showing a used IO cell according to the second embodiment;
FIG. 13 is a block diagram showing a used IO cell for a high voltage according to the second embodiment;
FIG. 14 is a block diagram showing a used IO cell for a low voltage according to the second embodiment;
FIG. 15 is a block diagram showing the ESD protective element according to the second embodiment;
FIG. 16 is a block diagram showing the ESD protective element according to the second embodiment;
FIG. 17 is a view schematically showing a method of arranging an ESD protective element according to the third embodiment;
FIG. 18 is a block diagram showing a used IO cell according to the third embodiment;
FIG. 19 is a block diagram showing the ESD protective element according to the third embodiment;
FIG. 20 is a block diagram showing the ESD protective element according to the third embodiment; and
FIG. 21 is a view schematically showing a method of arranging an ESD protective element according to a comparative example.

### DETAILED DESCRIPTION

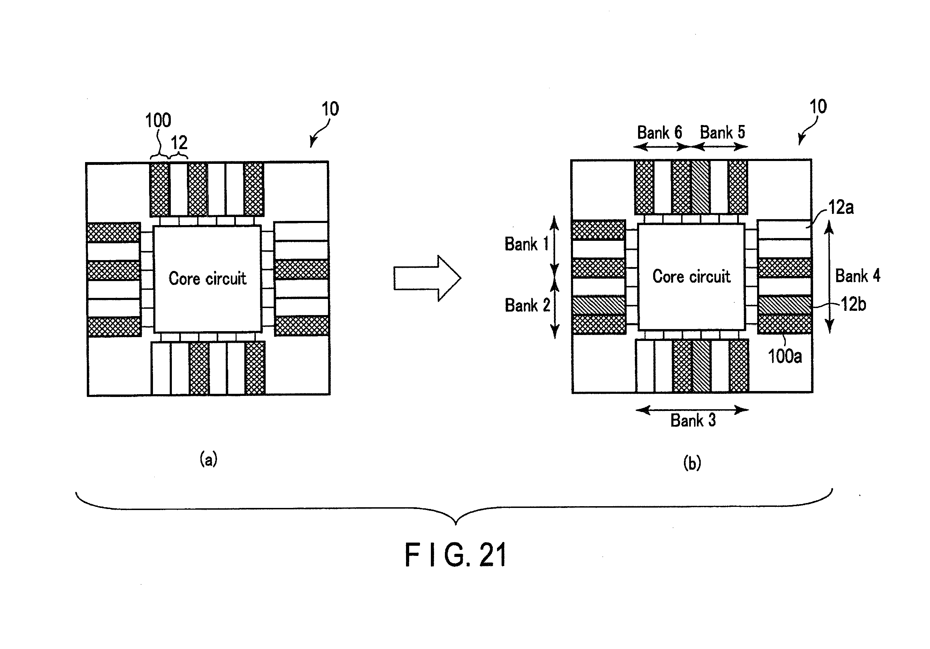

ESD is problematic in a structured array device that forms various semiconductor devices by changing the wiring connection and nonconnection relationship in each semiconductor element. Especially required is resistance to a surge voltage and a surge current generated by ESD applied to input/output cells (to be referred to as IO cells hereinafter) located on the periphery of a semiconductor chip in the structured array device. For this reason, as indicated by a comparative example shown by (a) of FIG. 21, not only regions (IO cell regions 12) where IO cells are formed but also regions (ESD dedicated regions 100) where ESD protective elements 100a are formed are arranged on the periphery of the semiconductor chip in advance.

After that, in the structured array device, used 10 cells 12a and unused IO cells 12b in the IO cell regions 12 are determined by the user, as indicated by the comparative example shown by (b) of FIG. 21. Only the used IO cells 12a are connected IO pads, and the unused IO cells 12b are unnecessary regions. The chip size becomes large because of existence of the unnecessary regions of the unused IO cells 12b.

In addition, as shown in (b) of FIG. 21, when the user determines the used IO cells 12a and the unused IO cells 12b, the IO cell regions 12 and the ESD dedicated regions 100 are divided into a plurality of banks Bank0 to Bank6 each formed from one power supply region. A predetermined number of ESD protective elements 100a (for example, one ESD protective element 100a) are necessary in each bank Bank. However, since the ESD protective elements 100a (ESD dedicated regions 100) are arbitrarily arranged in advance, extra ESD protective elements 100a may exist in each bank Bank. The presence of such extra ESD protective elements 100a increases the chip size.

To solve the problem, in this embodiment, the circuit arrangement of the unused IO cell 12b in the IO cell region 12 is changed to an ESD protective element 12c by changing the wiring connection and nonconnection relationship. This can reduce the chip size.

In general, according to one embodiment, a semiconductor device includes a first IO cell and a second IO cell arranged on a periphery of the core circuit. Each of the first IO cell and the second IO cell comprises: a power supply terminal to which a power supply voltage is applied; a ground terminal connected to ground; an RC delay circuit including a resistor having one terminal connected to one of the power supply terminal and the ground terminal and a capacitor having one terminal connected to the other terminal of the resistor and the other terminal connected to the other of the power supply terminal and the ground terminal; a P-type transistor; and an N-type transistor.

Embodiments will now be described with reference to the accompanying drawing. The same reference numerals denote the same parts throughout the drawing. A repetitive explanation will be made only when necessary.

### <First Embodiment>

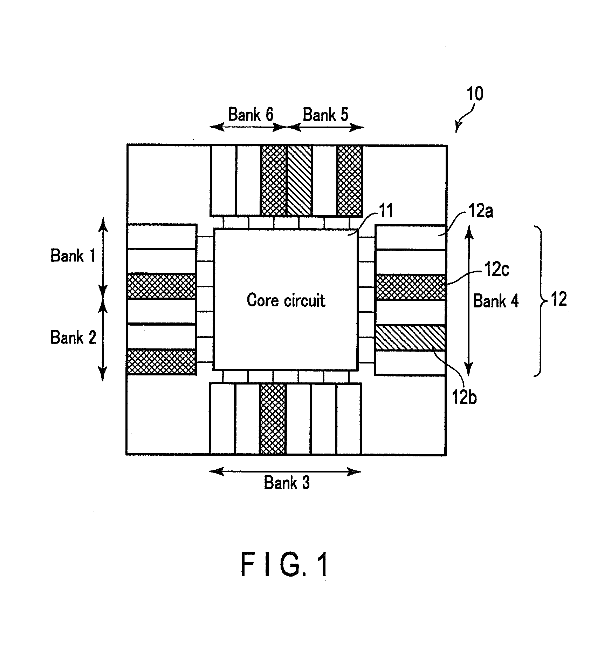

A semiconductor device according to the first embodiment will be described with reference to FIGS. 1, 2, 3, 4, and 5. In the first embodiment, an ESD protective element 12c is formed by changing the circuit arrangement of an unused IO cell 12b in an IO cell region 12. This can reduce the chip size. The first embodiment will be described below in detail.

### [Arrangement and Operation according to First Embodiment]

FIG. 1 is a view showing the layout of a semiconductor device (semiconductor chip) according to the first embodiment.

As shown in FIG. 1, a semiconductor chip 10 includes a core circuit 11, the IO cell regions 12, and a wiring layer 200 formed on them.

The core circuit 11 is arranged at the center of the semiconductor chip 10. The core circuit 11 is an internal circuit of the semiconductor chip other than the IO cell regions 12 electrically exchanging signals with the outside.

The IO cell regions 12 are arranged on the periphery of the semiconductor chip 10 and surround the core circuit 11. The IO cell regions 12 mainly function as input/output buffers in the electrical exchange between the core circuit 11 and the outside.

Each 10 cell region 12 includes a used IO cell 12a, the unused IO cell 12b, and the ESD protective element 12c. The used IO cell 12a is a cell that is used as an input/output buffer in the electrical exchange between the core circuit 11 and the outside. The used IO cell 12a is electrically connected to a pad (IO pad) electrically connected to the outside. The unused IO cell 12b is a cell that is not used as an input/output buffer in the electrical exchange between the core circuit 11 and the outside, and is not electrically connected to an IO pad. The ESD protective element 12c protects the IO cell region 12 from ESD that occurs in the IO cell region 12. Details of the circuit arrangement of these elements will be described later.

The IO cell regions 12 are divided into, for example, banks Bank1 to Bank6. Each bank Bank is formed from one power supply region. A predetermined number of ESD protective elements 12c are necessary in each bank Bank. Here, one ESD protective element 12c is arranged in each bank Bank. Note that the number of ESD protective elements 12c necessary in each bank Bank is determined by the gate width of a MOS transistor (shunt transistor) provided in the ESD protective element 12c.

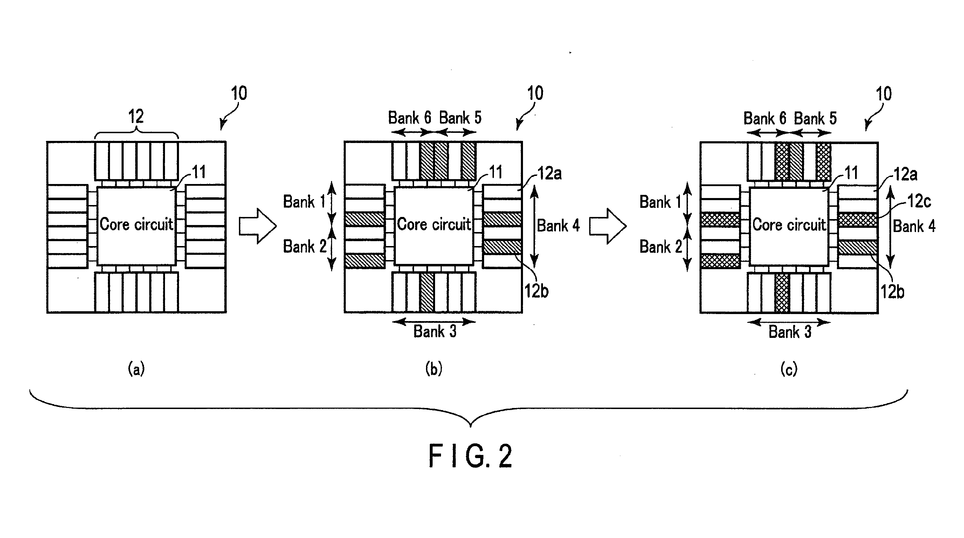

FIG. 2 is a view schematically showing a method of arranging an ESD protective element according to the first embodiment.

First, as shown in (a) of FIG. 2, the IO cell regions 12 are arranged on the periphery of the semiconductor chip 10. Each IO cell region 12 includes a plurality of cells (slots). Each cell includes various kinds of semiconductor elements so as to function as any of the used IO cell 12a, the unused IO cell 12b, and the ESD protective element 12c by rewriting the wiring (wiring layer 200).

Next, as shown in (b) of FIG. 2, each cell in the IO cell regions 12 is determined as the used IO cell 12a or the unused IO cell 12b. At this time, the IO cell regions 12 are divided into, for example, banks Bank1 to Bank6 on a power supply region basis.

Then, as shown in (c) of FIG. 2, some of the unused IO cells 12b are changed to the ESD protective elements 12c by rewriting the upper wiring. At this time, the wiring is rewritten such that a predetermined number of ESD protective elements 12c (here, one ESD protective element 12c) exist in each bank Bank.

A predetermined number of ESD protective elements 12c can thus be arranged in each bank Bank while reducing the unused IO cells 12b and reducing extra ESD protective elements 12c in the IO cell regions 12.

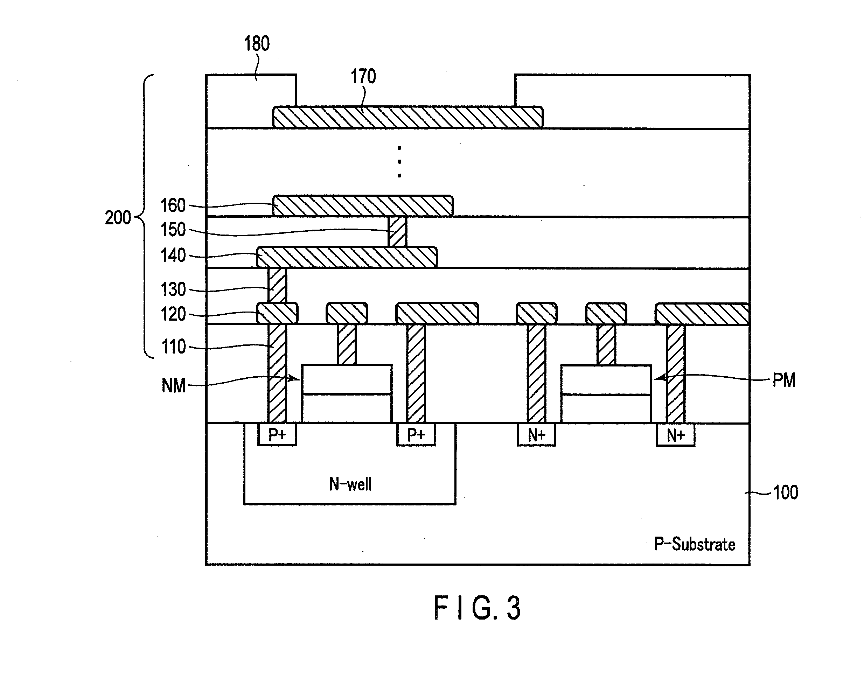

FIG. 3 is a sectional view showing an example of the IO cell or ESD protective element according to the first embodiment.

As shown in FIG. 3, the IO cells (used IO cell 12a and unused IO cell 12b) and the ESD protective element 12c have the same element structure. Each of the IO cells and the ESD protective element 12c includes elements such as an NMOS transistor NM and a PMOS transistor PM formed on a p type semiconductor substrate 100. Note that an RC delay circuit (to be described later) formed from a resistor and a capacitor is also included in such an element.

The NMOS transistor NM is formed on the p type semiconductor substrate 100. The NMOS transistor NM includes n+ type source and drain diffusion layers, a gate insulating layer, and a gate electrode. The gate insulating layer is located between the source and drain diffusion layers and formed on the semiconductor substrate 100. The gate electrode is formed on the gate insulating layer.

The PMOS transistor PM is formed on an n type well in the p type semiconductor substrate 100. The PMOS transistor PM includes p+ type source and drain diffusion layers, a gate insulating layer, and a gate electrode. The gate insulating layer is located between the source and drain diffusion layers and formed on the semiconductor substrate 100. The gate electrode is formed on the gate insulating layer.

A wiring layer 200 constituted by contacts 110, 130, 150 and wires 120, 140, 160, and 170 is formed above the NMOS transistor NM and the PMOS transistor PM. Interlayer dielectric films are formed between the wires 120, 140, 160, and 170, and the wires 120, 140, 160, and 170 are isolated. A passivation film 180 is formed to have an opening at part of the wire 170 of the uppermost layer.

The connection and non connection relationships between the source and drain diffusion layers and the gate electrodes of the NMOS transistor NM and the PMOS transistor PM are set by the wiring layer 200 provided above them.

More specifically, in the manufacturing process, after the elements (including RC delay circuit) such as the NMOS transistor NM and the PMOS transistor PM are formed on the semiconductor substrate 100, the wiring layer 200 having a wiring structure according to the cell is formed. That is, the wiring layer 200 whose wiring structure changes between a case where the cell is used as an IO cell and a case where the cell is used as the ESD protective element 12c is formed. As a result, in the IO cell, the elements are connected via the wiring layer 200 for the IO cell. In the ESD protective element 12c, the elements are connected via the wiring layer 200 for the ESD protective element.

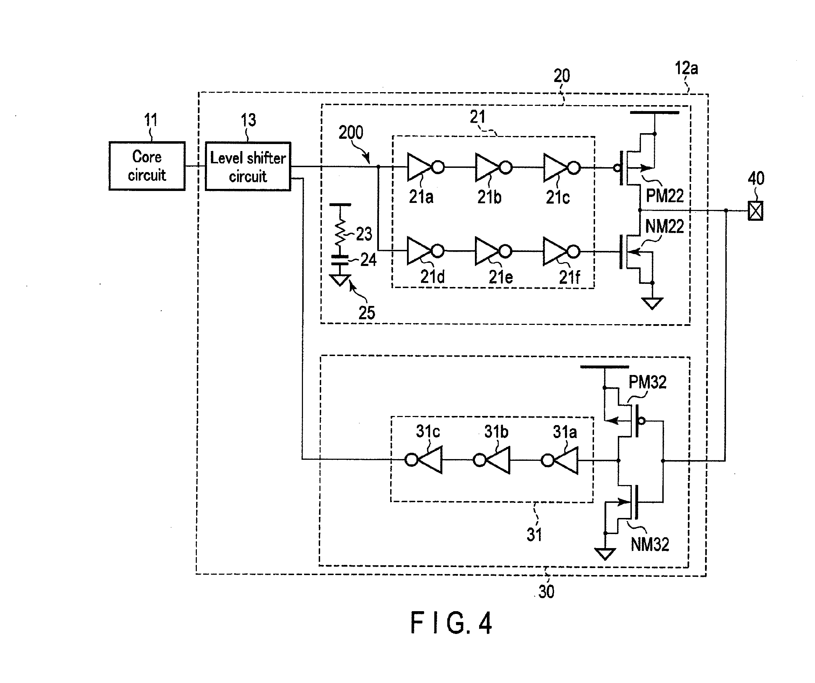

FIG. 4 is a block diagram showing a used IO cell according to the first embodiment.

As shown in FIG. 4, the used IO cell 12a includes an output circuit 20, an input circuit 30, a level shifter circuit 13, a first power supply terminal to which the same power supply as the core circuit 11 is supplied, a second power supply terminal that supplies power to the output circuit 20 and the input circuit 30, and a ground terminal.

The level shifter circuit 13 receives power by a first power supply terminal, a second power supply terminal, and a ground terminal, and has a function of shifting a signal potential at the boundary between different power supplies.

The output circuit 20 includes a power supply terminal (second power supply terminal) to which a power supply voltage is applied, a ground terminal connected to ground, a buffer circuit 21, an RC delay circuit 25, a PMOS transistor PM22, and an NMOS transistor NM22.

The buffer circuit 21 includes inverters 21a, 21b, 21c, 21d, 21e, and 21f. The inverters 21a, 21b, and 21c form an inverter chain, and the inverters 21d, 21e, and 21f form another inverter chain.

The inverter chain constituted by the inverters 21a, 21b, and 21c and the other inverter chain constituted by the inverters 21d, 21e, and 21f are arranged between the core circuit 11 and the gate of the PMOS transistor PM22 and that of the NMOS transistor NM22. The input terminals of these inverter chains are electrically connected to the core circuit 11 via the level shifter circuit 13, and the output terminals are electrically connected to the gate of the PMOS transistor PM22 and that of the NMOS transistor NM22.

More specifically, the input terminal of the inverter 21a is electrically connected to the core circuit 11 via the level shifter circuit 13, and the output terminal is electrically connected to the input terminal of the inverter 21b. The output terminal of the inverter 21b is electrically connected to the input terminal of the inverter 21c. The output terminal of the inverter 21c is electrically connected to the gate of the PMOS transistor PM22.

On the other hand, the input terminal of the inverter 21d is electrically connected to the core circuit 11 via the level shifter circuit 13, and the output terminal is electrically connected to the input terminal of the inverter 21e. The output terminal of the inverter 21e is electrically connected to the input terminal of the inverter 21f. The output terminal of the inverter 21f is electrically connected to the gate of the NMOS transistor NM22.

Note that in this example, the buffer circuit 21 includes two inverter chains to align the rises of the PMOS transistor PM22 and the NMOS transistor NM22. However, the present invention is not limited to this. If the rises of the PMOS transistor PM22 and the NMOS transistor NM22 are not problematic, the buffer circuit 21 may include one inverter chain. That is, the output terminal of one inverter chain is electrically connected to the gate of the PMOS transistor PM22 and that of the NMOS transistor NM22. In this example, each of the inverter chains between the level shifter circuit 13 and the PMOS transistor PM22 and between the level shifter circuit 13 and the NMOS transistor NM22 is formed as a three-stage inverter chain. However, the present invention is not limited to this, and various logically equivalent logic gates may be formed.

The source of the PMOS transistor PM22 is electrically connected to the power supply terminal, and the drain is electrically connected to an IO pad 40. The source of the NMOS transistor NM22 is electrically connected to the ground terminal, and the drain is electrically connected to the IO pad 40.

The RC delay circuit 25 is constituted by the series connected element of a resistor 23 and a capacitor 24. One terminal of the RC delay circuit 25 is electrically connected to the power supply terminal, and the other terminal is electrically connected to the ground terminal. More specifically, one terminal of the resistor 23 is electrically connected to the power supply terminal, and the other terminal is electrically connected to one terminal of the capacitor 24. The other terminal of the capacitor 24 is electrically connected to the ground terminal.

The output terminal (the node between the other terminal of the resistor 23 and one terminal of the capacitor 24) of the RC delay circuit 25 is not electrically connected to the PMOS transistor PM22 and the NMOS transistor NM22.

The input circuit 30 includes a power supply terminal to which the same power supply voltage as the output circuit 20 is supplied, a ground terminal connected to the same ground as the output circuit 20, a buffer circuit 31, a PMOS transistor PM32, and an NMOS transistor NM32.

The buffer circuit 31 includes inverters 31a, 31b, and 31c. The inverters 31a, 31b, and 31c constitute an inverter chain.

The inverter chain constituted by the inverters 31a, 31b, and 31c is arranged between the core circuit 11 and the drain of the PMOS transistor PM32 and that of the NMOS transistor NM32. The input terminal of this inverter chain is electrically connected to the drain of the PMOS transistor PM32 and that of the NMOS transistor NM32, and the output terminal is electrically connected to the core circuit 11 via the level shifter circuit 13.

More specifically, the input terminal of the inverter 31a is electrically connected to the drain of the PMOS transistor PM32 and that of the NMOS transistor NM32, and the output terminal is electrically connected to the input terminal of the inverter 31b. The output terminal of the inverter 31b is electrically connected to the input terminal of the inverter 31c. The output terminal of the inverter 31c is electrically connected to the core circuit 11 via the level shifter circuit 13.

The gate of the PMOS transistor PM32 is electrically connected to the IO pad 40, the source is electrically connected to the power supply terminal, and the drain is electrically connected to the input terminal of the inverter 31a. The gate of the NMOS transistor NM32 is electrically connected to the IO pad 40, the source is electrically connected to the ground terminal, and the drain is electrically connected to the input terminal of the inverter 31a.

Note that the unused IO cell 12b is a dummy circuit that does not particularly function (is not involved in circuit operation). The unused IO cell 12b can be either electrically connected so as not to affect other elements or disconnected (may be in a floating state).

The used IO cell 12a operates in the following way.

An output operation will be described first.

When an "H" level signal is input from the core circuit 11 to the output circuit 20 via the level shifter circuit 13, the output circuit 20 outputs an "H" level signal to the IO pad 40.

More specifically, when an "H" level signal is input to the inverter 21a, the inverter 21a inverts the input signal and outputs an "L" level signal. The inverter 21b inverts the input signal from the inverter 21a and outputs an "H" level signal. The inverter 21c inverts the input signal from the inverter 21b and outputs an "L" level signal. The "L" level signal is thus input to the gate of the PMOS transistor PM22, and the PMOS transistor PM22 is turned on.

When an "H" level signal is input to the inverter 21d, the inverter 21d inverts the input signal and outputs an "L" level signal. The inverter 21e inverts the input signal from the inverter 21d and outputs an "H" level signal. The inverter 21f inverts the input signal from the inverter 21e and outputs an "L" level signal. The "L" level signal is thus input to the gate of the NMOS transistor NM22, and the NMOS transistor NM22 is turned off.

As a result, since the power supply terminal is electrically connected to the IO pad 40 via the PMOS transistor PM22, the output circuit 20 outputs an "H" level signal to the outside (IO pad 40).

On the other hand, when an "L" level signal is input from the core circuit 11 to the output circuit 20 via the level shifter circuit 13, the PMOS transistor PM22 is turned off, and the NMOS transistor NM22 is turned on. As a result, since the ground terminal is electrically connected to the 10 pad 40 via the NMOS transistor NM22, the output circuit 20 outputs an "L" level signal to the outside (IO pad 40).

An input operation will be described next.

When an "H" level signal is input from the IO pad 40 to the input circuit 30, the input circuit 30 outputs an "H" level signal to the core circuit 11.

More specifically, when an "H" level signal is input to the gate of the PMOS transistor PM32 and that of the NMOS transistor NM32, the PMOS transistor PM32 is turned off, and the NMOS transistor NM32 is turned on. An "L" level signal is thus input from the ground terminal to the inverter 31a via the NMOS transistor NM32. When the "L" level signal is input to the inverter 31a, the inverter 31a inverts the input signal and outputs an "H" level signal. The inverter 31b inverts the input signal from the inverter 31a and outputs an "L" level signal. The inverter 31c inverts the input signal from the inverter 31b and outputs an "H" level signal.

As a result, the input circuit 30 outputs an "H" level signal to the core circuit 11 via the level shifter circuit 13.

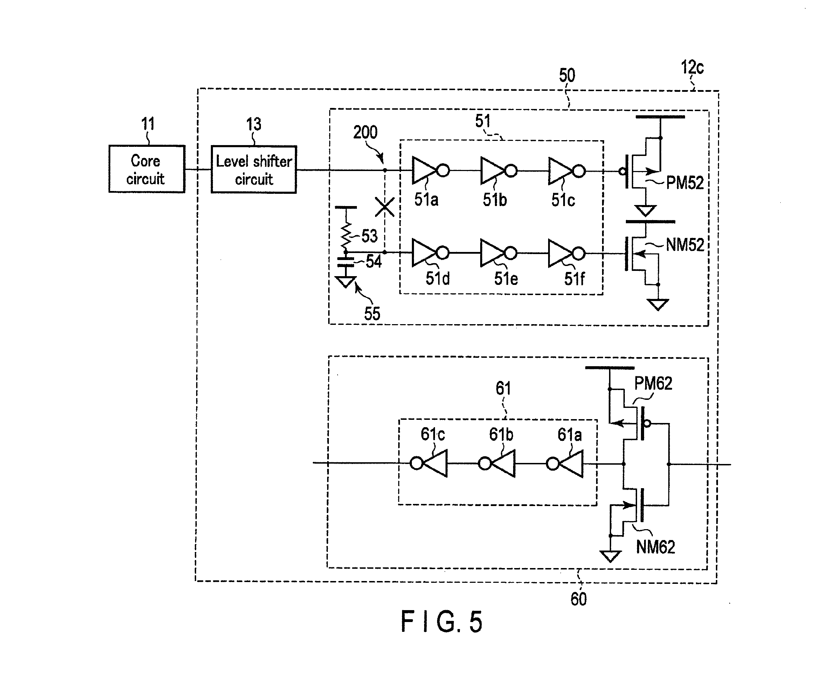

FIG. 5 is a block diagram showing the ESD protective element according to the first embodiment.

As shown in FIG. 5, the ESD protective element 12c includes an output change circuit 50 formed by rewiring the circuit elements of the output circuit 20 of the used IO cell 12a (unused IO cell 12b), an input change circuit 60 formed by rewiring the circuit elements of the input circuit 30, a first power supply terminal to which the same power supply as the core circuit 11 is supplied, a power supply terminal connected by wiring to the second power supply terminals of IO cells belonging to the same Bank, and a ground terminal connected by wiring to the ground terminals of IO cells belonging to the same Bank. For this reason, the ESD protective element 12c includes the same semiconductor elements as in the used IO cell 12a (unused IO cell 12b). The semiconductor elements in the ESD protective element 12c have the same arrangement as the semiconductor elements in the used IO cell 12a (unused IO cell 12b).

The output change circuit 50 includes a power supply terminal (second power supply terminal) to which a power supply voltage is applied, a ground terminal connected to ground, a buffer circuit 51, an RC delay circuit 55, a PMOS transistor PM52, and an NMOS transistor NM52.

The buffer circuit 51 includes inverters 51a, 51b, 51c, 51d, 51e, and 51f. The inverters 51d, 51e, and 51f constitute an inverter chain.

The inverter chain constituted by the inverters 51d, 51e, and 51f is arranged between the RC delay circuit 55 and the gate of the NMOS transistor NM52. The input terminal of this inverter chain is electrically connected to the output terminal (the node between the other terminal of a resistor 53 and one terminal of a capacitor 54) of the RC delay circuit 55, and the output terminal of the above inverter chain is electrically connected to the gate of the NMOS transistor NM52.

More specifically, the input terminal of the inverter 51d is electrically connected to the output terminal of the RC delay circuit 55, and the output terminal of the inverter 51d is electrically connected to the input terminal of the inverter 51e. The output terminal of the inverter 51e is electrically connected to the input terminal of the inverter 51f. The output terminal of the inverter 51f is electrically connected to the gate of the NMOS transistor NM52.

The source of the NMOS transistor NM52 is electrically connected to the ground terminal, and the drain is electrically connected to the power supply terminal. In this example, the NMOS transistor NM52 functions as a shunt transistor.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the power supply terminal, and the other terminal is electrically connected to one terminal of the capacitor 54. The other terminal of the capacitor 54 is electrically connected to the ground terminal.

The output terminal (the node between the other terminal of the resistor 53 and one terminal of the capacitor 54) of the RC delay circuit 55 is electrically connected to the gate of the NMOS transistor NM52 via the inverter chain constituted by the inverters 51d, 51e, and 51f.

Note that the inverter chain need not always be constituted by the three inverters 51d, 51e, and 51f. Since the gate of the NMOS transistor NM52 is at "L" level in a steady state, the inverter chain need only be constituted by an odd number of inverters or logic gates equivalent to the inverters.

The inverters 51a, 51b, and 51c and the PMOS transistor PM52 are dummy elements that do not particularly function. For this reason, the inverters 51a, 51b, and 51c and the PMOS transistor PM52 can be either electrically connected so as not to affect other elements or disconnected (may be in a floating state).

The input change circuit 60 includes a power supply terminal to which the same power supply voltage as the output change circuit 50 is supplied, a ground terminal connected to the same ground as the output change circuit 50, a buffer circuit 61, a PMOS transistor PM62, and an NMOS transistor NM62.

The input change circuit 60 is a dummy element that does not particularly function. For this reason, inverters 61a, 61b, and 61c, the PMOS transistor PM62, and the NMOS transistor NM62 in the input change circuit 60 can be either electrically connected so as not to affect other elements or disconnected (may be in a floating state).

The ESD protective element 12c operates in the following way.

In a steady state, the RC delay circuit outputs an "H" level signal. When the "H" level signal is input to the inverter 51d, the inverter 51d inverts the input signal and outputs an "L" level signal. The inverter 51e inverts the input signal from the inverter 51d and outputs an "H" level signal. The inverter 51f inverts the input signal from the inverter 51e and outputs an "L" level signal. As a result, the NMOS transistor NM52 (shunt transistor) is turned off, and the ESD protective element 12c does not operate.

On the other hand, when an ESD surge voltage having a short rise time is input to the power supply terminal, it takes a time of a time constant determined by the product of the resistance value and the capacitance value until the capacitor 54 is charged via the resistor 53 in the RC delay circuit 55. For this reason, the inverter 51d outputs an "H" level signal during the period until the output of the RC delay circuit 55 exceeds the threshold voltage of the inverter 51d. Hence, the inverter 51e inverts the input signal from the inverter 51d and outputs an "L" level signal. The inverter 51f inverts the input signal from the inverter 51e and outputs an "H" level signal. As a result, the NMOS transistor NM52 is turned on, and a surge current is discharged from the power supply terminal to the ground terminal. The ESD protective element 12c thus detects the leading edge of the surge voltage applied to the power supply terminal and turns on the NMOS transistor NM52 during the period determined by the product of the resistance value and the capacitance value, thereby performing a discharge operation.

### [Effects of First Embodiment]

According to the first embodiment, the ESD protective element 12c is formed by changing the circuit arrangement of the unused IO cell 12b in the IO cell region 12 by rewiring. This can reduce unnecessary regions of the unused IO cells 12b. It is also possible to form a predetermined number of ESD protective elements 12c in each bank Bank and reduce the extra ESD protective elements 12c. As a result, the chip size can be reduced.

### [Modifications]

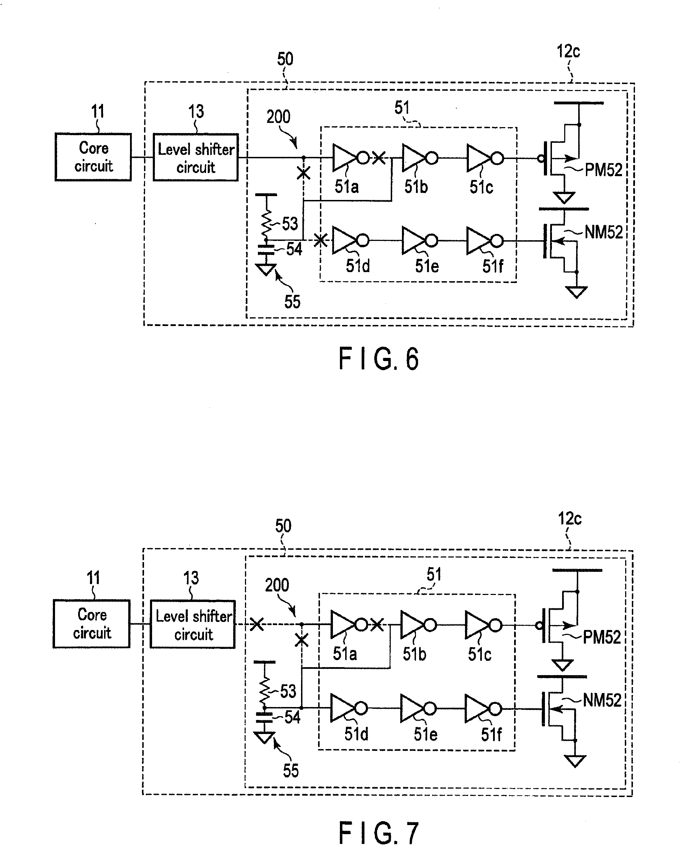

FIGS. 6, 7, 8, 9, and 10 are block diagrams showing Modifications 1 to 5 of the ESD protective element according to the first embodiment. Note that although the input change circuit 60 is not illustrated in FIGS. 6, 7, 8, 9, and 10, there no substantial difference in the arrangement. In the modifications, differences from the first embodiment will mainly be explained.

As shown in FIG. 6, in the ESD protective element 12c according to Modification 1, the inverters 51b and 51c form an inverter chain, and the PMOS transistor PM52 functions as a shunt transistor.

The inverter chain constituted by the inverters 51b and 51c is arranged between the RC delay circuit 55 and the gate of the PMOS transistor PM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the PMOS transistor PM52.

More specifically, the input terminal of the inverter 51b is electrically connected to the output terminal of the RC delay circuit 55, and the output terminal of the inverter 51b is electrically connected to the input terminal of the inverter 51c. The output terminal of the inverter 51c is electrically connected to the gate of the PMOS transistor PM52.

Note that the inverter chain need not always be constituted by the two inverters 51b and 51c. Since the gate of the PMOS transistor PM52 is at "H" level in a steady state, the inverter chain need only be constituted by an even number of inverters or logic gates equivalent to the inverters. Alternatively, the output terminal of the RC delay circuit 55 and the gate of the PMOS transistor PM52 may be directly electrically connected without arranging the inverters.

The inverters 51a, 51d, 51e, and 51f and the NMOS transistor NM52 are dummy elements that do not particularly function. For this reason, the inverters 51a, 51d, 51e, and 51f and the NMOS transistor NM52 can be either electrically connected so as not to affect other elements or disconnected (may be in a floating state).

As shown in FIG. 7, in the ESD protective element 12c according to Modification 2, the inverters 51b and 51c form an inverter chain, and the inverters 51d, 51e, and 51f form another inverter chain. In this example, the NMOS transistor NM52 and the PMOS transistor PM52 function as shunt transistors.

The inverter chain formed from the inverters 51b and 51c is arranged between the RC delay circuit 55 and the gate of the PMOS transistor PM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the PMOS transistor PM52.

More specifically, the input terminal of the inverter 51b is electrically connected to the output terminal of the RC delay circuit 55, and the output terminal of the inverter 51b is electrically connected to the input terminal of the inverter 51c. The output terminal of the inverter 51c is electrically connected to the gate of the PMOS transistor PM52.

The inverter chain constituted by the inverters 51d, 51e, and 51f is arranged between the RC delay circuit 55 and the gate of the NMOS transistor NM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the NMOS transistor NM52.

More specifically, the input terminal of the inverter 51d is electrically connected to the output terminal of the RC delay circuit 55, and the output terminal of the inverter 51d is electrically connected to the input terminal of the inverter 51e. The output terminal of the inverter 51e is electrically connected to the input terminal of the inverter 51f. The output terminal of the inverter 51f is electrically connected to the gate of the NMOS transistor NM52.

The inverter 51a is a dummy element that does not particularly function. For this reason, the inverter 51a can be either electrically connected so as not to affect other elements or disconnected (may be in a floating state).

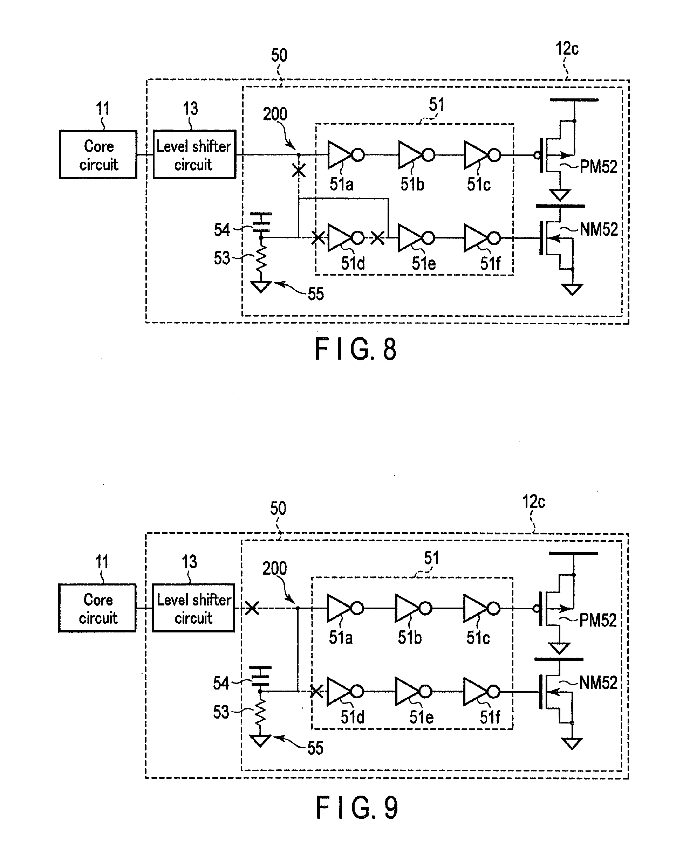

As shown in FIG. 8, in the ESD protective element 12c according to Modification 3, the connection relationship between the resistor 53 and the capacitor 54 included in the RC delay circuit 55 is reverse to that of the first embodiment. In this example, the inverters 51e and 51f form an inverter chain. Additionally, in this example, the NMOS transistor NM52 functions as a shunt transistor.

The inverter chain constituted by the inverters 51e and 51f is arranged between the RC delay circuit 55 and the gate of the NMOS transistor NM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the NMOS transistor NM52.

More specifically, the input terminal of the inverter 51e is electrically connected to the output terminal of the RC delay circuit 55, and the output terminal of the inverter 51e is electrically connected to the input terminal of the inverter 51f. The output terminal of the inverter 51f is electrically connected to the gate of the NMOS transistor NM52.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the ground terminal, and the other terminal is electrically connected to one terminal of the capacitor 54. The other terminal of the capacitor 54 is electrically connected to the power suply terminal.

Note that the inverter chain need not always be constituted by the two inverters 51e and 51f. Since the gate of the NMOS transistor NM52 is at "L" level in a steady state, the inverter chain need only be constituted by an even number of inverters or logic gates equivalent to the inverters. Alternatively, the output terminal of the RC delay circuit 55 and the gate of the NMOS transistor NM52 may be directly electrically connected without arranging the inverters.

The inverters 51a, 51b, 51c, and 51d and the PMOS transistor PM52 are dummy elements that do not particularly function. For this reason, the inverters 51a, 51b, 51c, and 51d and the PMOS transistor PM52 can be either electrically connected so as not to affect other elements or disconnected (may be in a floating state).

As shown in FIG. 9, in the ESD protective element 12c according to Modification 4, the connection relationship between the resistor 53 and the capacitor 54 included in the RC delay circuit 55 is reverse to that of the first embodiment. In this example, the inverters 51a, 51b, and 51c form an inverter chain. Additionally, in this example, the PMOS transistor PM52 functions as a shunt transistor.

The inverter chain constituted by the inverters 51a, 51b, and 51c is arranged between the RC delay circuit 55 and the gate of the PMOS transistor PM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the PMOS transistor PM52.

More specifically, the input terminal of the inverter 51a is electrically connected to the output terminal of the RC delay circuit 55, and the output terminal of the inverter 51a is electrically connected to the input terminal of the inverter 51b. The output terminal of the inverter 51b is electrically connected to the input terminal of the inverter 51c. The output terminal of the inverter 51c is electrically connected to the gate of the PMOS transistor PM52.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the ground terminal, and the other terminal is electrically connected to one terminal of the capacitor 54. The other terminal of the capacitor 54 is electrically connected to the power supply terminal.

Note that the inverter chain need not always be constituted by the three inverters 51a, 51b, and 51c. Since the gate of the PMOS transistor PM52 is at "H" level in a steady state, the inverter chain need only be formed from an odd number of inverters or logic gates equivalent to the inverters.

The inverters 51d, 51e, and 51f and the NMOS transistor NM52 are dummy elements that do not particularly function. For this reason, the inverters 51d, 51e, and 51f and the NMOS transistor NM52 can be either electrically connected so as not to affect other elements or disconnected (may be in a floating state).

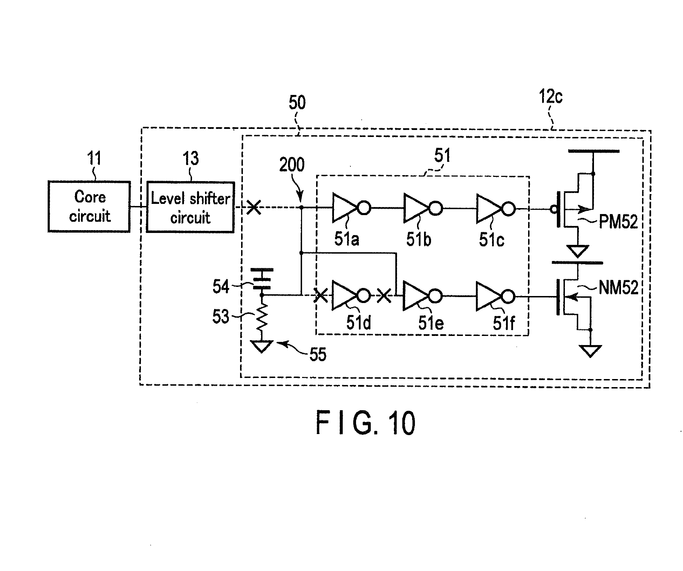

As shown in FIG. 10, in the ESD protective element 12c according to Modification 5, the connection relationship between the resistor 53 and the capacitor 54 included in the RC delay circuit 55 is reverse to that of the first embodiment. In this example, the inverters 51a, 51b, and 51c form an inverter chain, and the inverters 51e and 51f form another inverter chain. Additionally, in this example, the NMOS transistor NM52 and the PMOS transistor PM52 function as shunt transistors.

The inverter chain constituted by the inverters 51a, 51b, and 51c is arranged between the RC delay circuit 55 and the gate of the PMOS transistor PM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the PMOS transistor PM52.

More specifically, the input terminal of the inverter 51a is electrically connected to the output terminal of the RC delay circuit 55, and the output terminal of the inverter 51a is electrically connected to the input terminal of the inverter 51b. The output terminal of the inverter 51b is electrically connected to the input terminal of the inverter 51c. The output terminal of the inverter 51c is electrically connected to the gate of the PMOS transistor PM52.

The inverter chain constituted by the inverters 51e and 51f is arranged between the RC delay circuit 55 and the gate of the NMOS transistor NM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the NMOS transistor NM52.

More specifically, the input terminal of the inverter 51e is electrically connected to the output terminal of the RC delay circuit 55, and the output terminal of the inverter 51e is electrically connected to the input terminal of the inverter 51f. The output terminal of the inverter 51f is electrically connected to the gate of the NMOS transistor NM52.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the ground terminal, and the other terminal is electrically connected to one terminal of the capacitor 54. The other terminal of the capacitor 54 is electrically connected to the power supply terminal.

Note that the inverter chain need not always be constituted by the two inverters 51e and 51f. Since the gate of the NMOS transistor NM52 is at "L" level in a steady state, the inverter chain need only be constituted by an even number of inverters or logic gates equivalent to the inverters. Alternatively, the output terminal of the RC delay circuit 55 and the gate of the NMOS transistor NM52 may be directly electrically connected without arranging the inverters.

In addition, the inverter chain need not always be constituted by the three inverters 51a, 51b, and 51c. Since the gate of the PMOS transistor PM52 is at "H" level in a steady state, the inverter chain need only be constituted by an odd number of inverters or logic gates equivalent to the inverters.

The inverter 51d is a dummy element that does not particularly function. For this reason, the inverter 51d can be either electrically connected so as not to affect other elements or disconnected (may be in a floating state).

### <Second Embodiment>

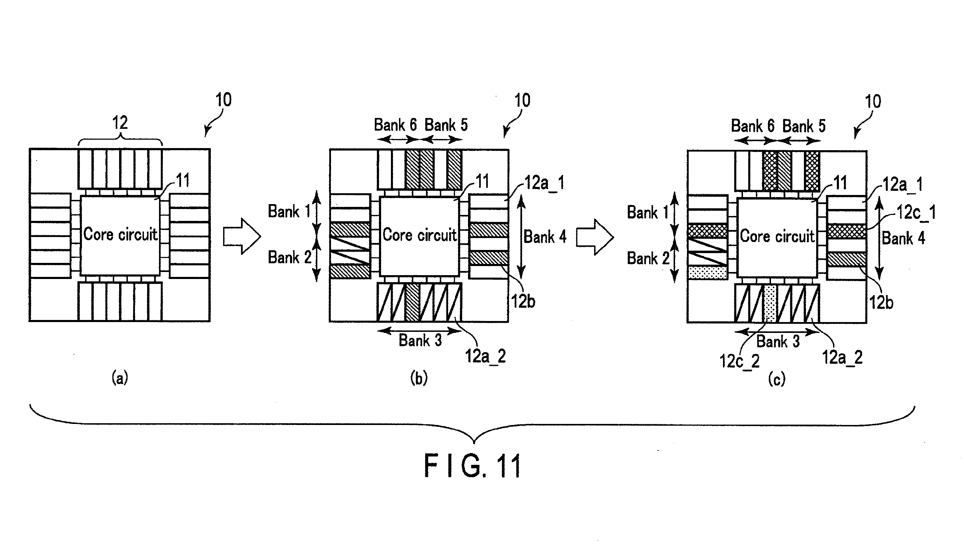

A semiconductor device according to the second embodiment will be described with reference to FIGS. 11, 12, 13, 14, 15, and 16. In the second embodiment, each of a used IO cell 12a and an ESD protective element 12c has a circuit arrangement for a high voltage and that for a low voltage. This allows the used IO cell 12a and the ESD protective element 12c to selectively use a withstand voltage for a high voltage or a low voltage. The second embodiment will be described below in detail.

Note that in the second embodiment, a description of the same points as in the first embodiment will be omitted, and differences will mainly be explained.

### [Arrangement according to Second Embodiment]

FIG. 11 is a view schematically showing a method of arranging an ESD protective element according to the second embodiment.

First, as shown in (a) of FIG. 11, IO cell regions 12 are arranged on the periphery of a semiconductor chip 10. Each IO cell region 12 includes a plurality of cells (slots). Each cell includes various kinds of semiconductor elements so as to function as any of the used 10 cell 12a, an unused IO cell 12b, and the ESD protective element 12c by rewiring.

Next, as shown in (b) of FIG. 11, each cell in the IO cell regions 12 is determined as the used IO cell 12a or the unused IO cell 12b. Each used IO cell 12a is selectively used as a high voltage used IO cell 12a_1 or a low voltage used IO cell 12a_2. At this time, the IO cell regions 12 are divided into, for example, banks Bank1 to Bank6. Each of the banks Bank1 to Bank6 has a power supply region basis.

Then, as shown in (c) of FIG. 11, some of the unused IO cells 12b are changed to the ESD protective elements 12c by rewiring the upper wiring. Each ESD protective element 12c is selectively used as a high voltage ESD protective element 12c_1 or a low voltage ESD protective element 12c_2. At this time, the wiring is rewired such that a predetermined number of ESD protective elements 12c (here, one ESD protective element 12c) exist in each bank Bank.

A predetermined number of ESD protective elements 12c can thus be arranged in each bank Bank while reducing the unused IO cells 12b and reducing extra ESD protective elements 12c in the IO cell regions 12.

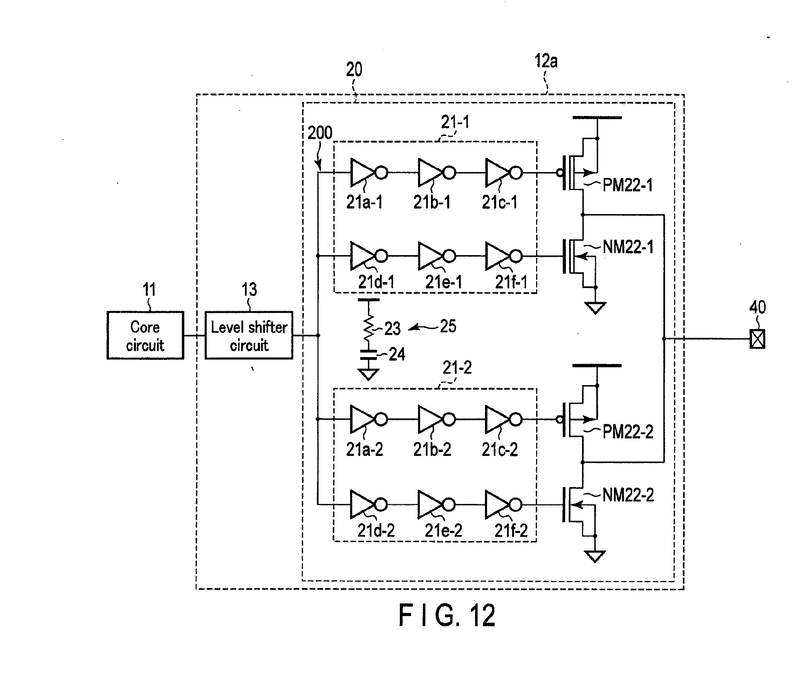

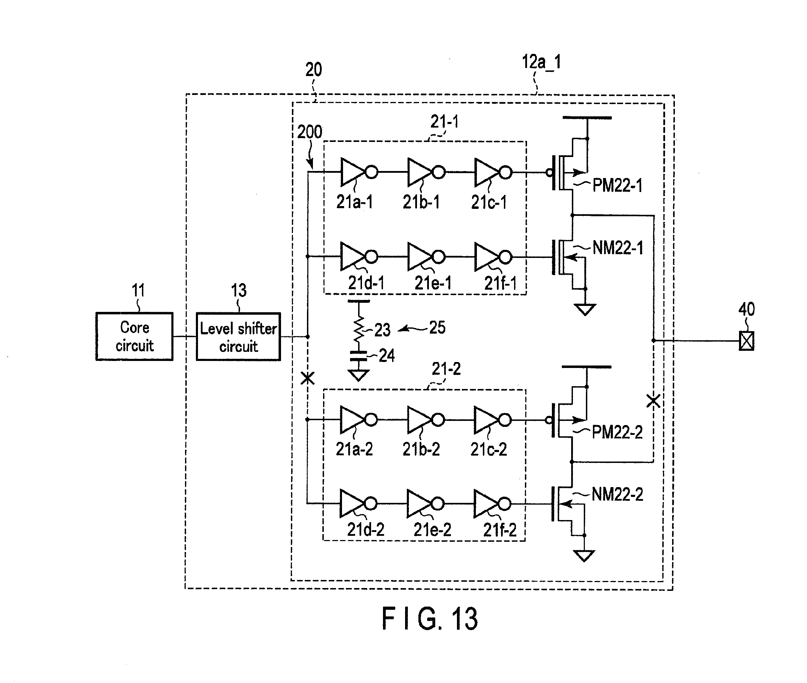

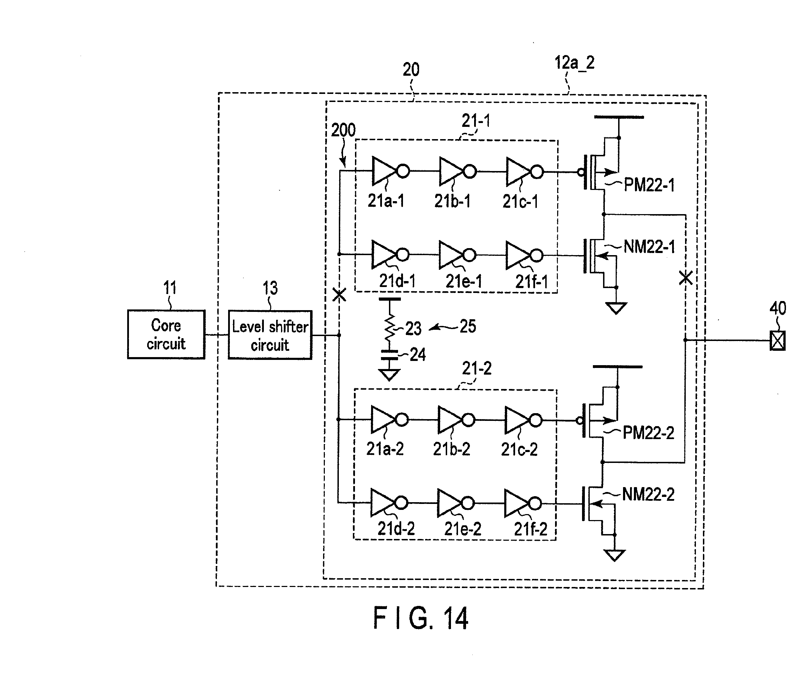

FIG. 12 is a block diagram showing a used IO cell according to the second embodiment. FIG. 13 is a block diagram showing a used IO cell for a high voltage according to the second embodiment. FIG. 14 is a block diagram showing a used IO cell for a low voltage according to the second embodiment. Note that the input circuit is not illustrated here.

As shown in FIG. 12, the used IO cell 12a according to the second embodiment includes an output circuit 20, a level shifter circuit 13, a first power supply terminal to which the same power supply as a core circuit 11 is supplied, a second power supply terminal that supplies power to the output circuit 20, and a ground terminal.

The output circuit 20 includes an RC delay circuit 25, a high withstand voltage buffer circuit 21_1, a high withstand voltage PMOS transistor PM22_1, a high withstand voltage NMOS transistor NM22_1, a low withstand voltage buffer circuit 21_2, a low withstand voltage PMOS transistor PM22_2, and a low withstand voltage NMOS transistor NM22_2.

The high withstand voltage buffer circuit 21_1 includes high withstand voltage inverters 21a_1, 21b_1, 21c_1, 21d_1, 21e_1, and 21f_1. The high withstand voltage inverters 21a_1, 21b_1, and 21c_1 form an inverter chain, and the high withstand voltage inverters 21d_1, 21e_1, and 21f_1 form another inverter chain.

The inverter chain constituted by the high withstand voltage inverters 21a_1, 21b_1, and 21c_1 and the high withstand voltage inverter chain constituted by the inverters 21d_1, 21e_1, and 21f_1 are arranged between the core circuit 11 and the gate of the high withstand voltage PMOS transistor PM22_1 and that of the high withstand voltage NMOS transistor NM22_1. When the used IO cell is used as the high voltage used IO cell 12a_1, the input terminals of these inverter chains are electrically connected to the core circuit 11 via the level shifter circuit 13, and the output terminals are electrically connected to the gate of the high withstand voltage PMOS transistor PM22_1 and that of the high withstand voltage NMOS transistor NM22_1.

More specifically, as shown in FIG. 13, when the used IO cell is used as the high voltage used IO cell 12a_1, the input terminal of the high withstand voltage inverter 21a_1 is electrically connected to the core circuit 11 via the level shifter circuit 13, and the output terminal is electrically connected to the input terminal of the high withstand voltage inverter 21b_1. The output terminal of the high withstand voltage inverter 21b_1 is electrically connected to the input terminal of the high withstand voltage inverter 21c_1. The output terminal of the high withstand voltage inverter 21c_1 is electrically connected to the gate of the high withstand voltage PMOS transistor PM22_1.

When the used IO cell is used as the high voltage used IO cell 12a_1, the input terminal of the high withstand voltage inverter 21d_1 is electrically connected to the core circuit 11 via the level shifter circuit 13, and the output terminal is electrically connected to the input terminal of the high withstand voltage inverter 21e_1. The output terminal of the high withstand voltage inverter 21e_1 is electrically connected to the input terminal of the high withstand voltage inverter 21f_1. The output terminal of the high withstand voltage inverter 21f_1 is electrically connected to the gate of the high withstand voltage NMOS transistor NM22_1.

The source of the high withstand voltage PMOS transistor PM22_1 is electrically connected to the power supply terminal, and the drain is electrically connected to an IO pad 40. The source of the high withstand voltage NMOS transistor NM22_1 is electrically connected to the ground terminal, and the drain is electrically connected to the IO pad 40.

The low withstand voltage buffer circuit 21_2 includes low withstand voltage inverters 21a_2, 21b_2, 21c_2, 21d_2, 21e_2, and 21f_2. The low withstand voltage inverters 21a_2, 21b_2, and 21c_2 form an inverter chain, and the low withstand voltage inverters 21d_2, 21e_2, and 21f_2 form another inverter chain.

The inverter chain constituted by the low withstand voltage inverters 21a_2, 21b_2, and 21c_2 and the low withstand voltage inverter chain constituted by the inverters 21d_2, 21e_2, and 21f_2 are arranged between the core circuit 11 and the gate of the low withstand voltage PMOS transistor PM22_2 and that of the low withstand voltage NMOS transistor NM22_2. When the used IO cell is used as the low voltage used IO cell 12a_2, the input terminals of these inverter chains are electrically connected to the core circuit 11 via the level shifter circuit 13, and the output terminals are electrically connected to the gate of the low withstand voltage PMOS transistor PM22_2 and that of the low withstand voltage NMOS transistor NM22_2.

More specifically, as shown in FIG. 14, when the used IO cell is used as the low voltage used IO cell 12a_2, the input terminal of the low withstand voltage inverter 21a_2 is electrically connected to the core circuit 11 via the level shifter circuit 13, and the output terminal is electrically connected to the input terminal of the low withstand voltage inverter 21b_2. The output terminal of the low withstand voltage inverter 21b_2 is electrically connected to the input terminal of the low withstand voltage inverter 21c_2. The output terminal of the low withstand voltage inverter 21c_2 is electrically connected to the gate of the low withstand voltage PMOS transistor PM22_2.

When the used IO cell is used as the low voltage used IO cell 12a_2, the input terminal of the low withstand voltage inverter 21d_2 is electrically connected to the core circuit 11 via the level shifter circuit 13, and the output terminal is electrically connected to the input terminal of the low withstand voltage inverter 21e_2. The output terminal of the low withstand voltage inverter 21e_2 is electrically connected to the input terminal of the low withstand voltage inverter 21f_2. The output terminal of the low withstand voltage inverter 21f_2 is electrically connected to the gate of the low withstand voltage NMOS transistor NM22_2.

The source of the low withstand voltage PMOS transistor PM22_2 is electrically connected to the power supply terminal, and the drain is electrically connected to the IO pad 40. The source of the low withstand voltage NMOS transistor NM22_2 is electrically connected to the ground terminal, and the drain is electrically connected to the IO pad 40.

The RC delay circuit 25 is constituted by the series connected element of a resistor 23 and a capacitor 24. One terminal of the RC delay circuit 25 is electrically connected to the power supply terminal, and the other terminal is electrically connected to the ground terminal. More specifically, one terminal of the resistor 23 is electrically connected to the power supply terminal, and the other terminal is electrically connected to one terminal of the capacitor 24. The other terminal of the capacitor is electrically connected to the ground terminal.

The output terminal (the node between the other terminal of the resistor 23 and one terminal of the capacitor 24) of the RC delay circuit 25 is not electrically connected to the high withstand voltage PMOS transistor PM22_1 and the high withstand voltage NMOS transistor NM22_1. In addition, the output terminal of the RC delay circuit 25 is not electrically connected to the low withstand voltage PMOS transistor PM22_2 and the low withstand voltage NMOS transistor NM22_2.

Note that when the used IO cell is used as the high voltage used IO cell 12a_1, the low withstand voltage buffer circuit 21_2, the low withstand voltage PMOS transistor PM22_2, and the low withstand voltage NMOS transistor NM22_2 are dummy elements that do not particularly function. For this reason, the low withstand voltage buffer circuit 21_2, the low withstand voltage PMOS transistor PM22_2, and the low withstand voltage NMOS transistor NM22_2 can be either electrically connected so as not to affect other elements or disconnected (may be in a floating state).

When the used IO cell is used as the low voltage used IO cell 12a_2, the high withstand voltage buffer circuit 21_1, the high withstand voltage PMOS transistor PM22_1, and the high withstand voltage NMOS transistor NM22_1 are dummy elements that do not particularly function. For this reason, the high withstand voltage buffer circuit 21_1, the high withstand voltage PMOS transistor PM22_1, and the high withstand voltage NMOS transistor NM22_1 can be either electrically connected so as not to affect other elements or disconnected (may be in a floating state).

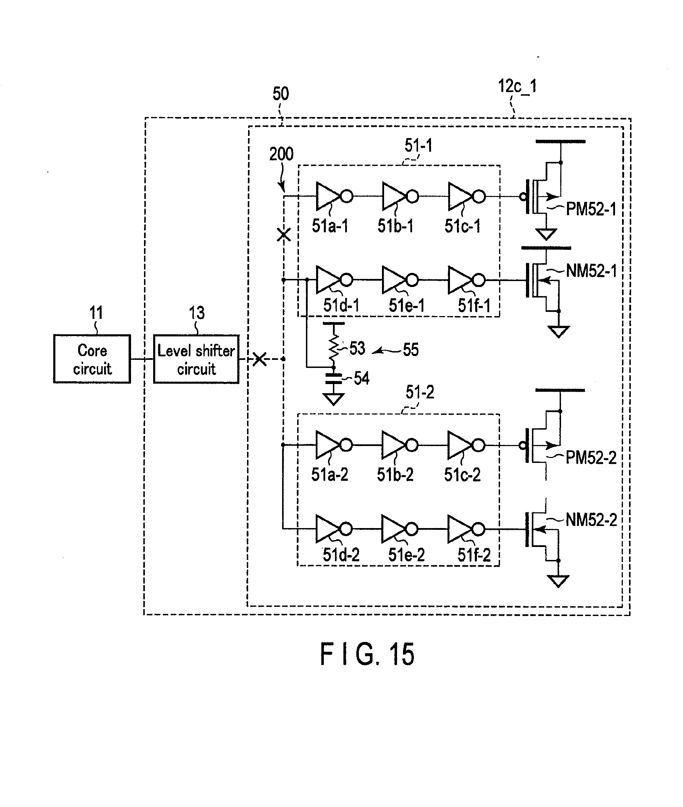

FIG. 15 is a block diagram showing the ESD protective element according to the second embodiment. Note that FIG. 15 does not illustrate the input circuit. FIG. 15 shows connection in a case where the ESD protective element 12c is used as the high voltage ESD protective element 12c_1.

As shown in FIG. 15, the high voltage ESD protective element 12c_1 includes an output change circuit 50 formed by rewiring the circuit elements of the output circuit 20 of the used IO cell 12a (unused IO cell 12b). For this reason, the high voltage ESD protective element 12c_1 includes the same semiconductor elements as in the used IO cell 12a (unused IO cell 12b). The semiconductor elements in the high voltage ESD protective element 12c_1 have the same arrangement as the semiconductor elements in the used IO cell 12a (unused IO cell 12b).

The high voltage ESD protective element 12c_1 (output change circuit 50) includes the level shifter circuit 13, a power supply terminal connected by wiring to the second power supply terminals of IO cells belonging to the same Bank, a ground terminal connected by wiring to the ground terminals of IO cells belonging to the same Bank, an RC delay circuit 55, a high withstand voltage buffer circuit 51_1, a high withstand voltage PMOS transistor PM52_1, a high withstand voltage NMOS transistor NM52_1, a low withstand voltage buffer circuit 51_2, a low withstand voltage PMOS transistor PM52_2, and a low withstand voltage NMOS transistor NM52_2.

The high withstand voltage buffer circuit 51_1 includes high withstand voltage inverters 51a_1, 51b_1, 51c_1, 51d_1, 51e_1, and 51f_1. The high withstand voltage inverters 51d_1, 51e_1, and 51f_1 form an inverter chain.

The inverter chain constituted by the high withstand voltage inverters 51d_1, 51e_1, and 51f_1 is arranged between the RC delay circuit 55 and the gate of the high withstand voltage NMOS transistor NM52_1. The input terminal of this inverter chain is electrically connected to the output terminal (the node between the other terminal of a resistor 53 and one terminal of a capacitor 54) of the RC delay circuit 55, and the output terminal of the above inverter chain is electrically connected to the gate of the high withstand voltage NMOS transistor NM52_1.

More specifically, the input terminal of the high withstand voltage inverter 51d_1 is electrically connected to the output terminal of the RC delay circuit 55, and the output terminal of the inverter 51d_1 is electrically connected to the input terminal of the high withstand voltage inverter 51e_1. The output terminal of the high withstand voltage inverter 51e_1 is electrically connected to the input terminal of the high withstand voltage inverter 51f_1. The output terminal of the high withstand voltage inverter 51f_1 is electrically connected to the gate of the high withstand voltage NMOS transistor NM52_1.

The source of the high withstand voltage NMOS transistor NM52_1 is electrically connected to the ground terminal, and the drain is electrically connected to the power supply terminal. In this example, the high withstand voltage NMOS transistor NM52_1 functions as a shunt transistor.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the power supply terminal, and the other terminal is electrically connected to one terminal of the capacitor 54. The other terminal of the capacitor is electrically connected to the ground terminal.

The output terminal (the node between the other terminal of the resistor 53 and one terminal of the capacitor 54) of the RC delay circuit 55 is electrically connected to the gate of the high withstand voltage NMOS transistor NM52_1 via the inverter chain constituted by the high withstand voltage inverters 51d_1, 51e_1, and 51f_1.

Note that the inverter chain need not always be constituted by the three high withstand voltage inverters 51d_1, 51e_1, and 51f_1. Since the gate of the high withstand voltage NMOS transistor NM52_1 is at "L" level in a steady state, the inverter chain need only be constituted by an odd number of high withstand voltage inverters or logic gates equivalent to the inverters.

The high withstand voltage inverters 51a_1, 51b_1, and 51c_1 and the high withstand voltage PMOS transistor PM52_1 are dummy elements that do not particularly function. For this reason, the high withstand voltage inverters 51a_1, 51b_1, and 51c_1 and the high withstand voltage PMOS transistor PM52_1 can be either electrically connected so as not to affect other elements or disconnected (may be in a floating state).

When the ESD protective element 12c is used as the high voltage ESD protective element 12c_1, the low withstand voltage buffer circuit 51_2, the low withstand voltage PMOS transistor PM52_2, and the low withstand voltage NMOS transistor NM52_2 are dummy elements that do not particularly function. For this reason, low withstand voltage inverters 51a_2, 51b_2, 51c_2, 51d_2, 51e_2, and 51f_2, the low withstand voltage PMOS transistor PM52_2, and the low withstand voltage NMOS transistor NM52_2 can be either electrically connected so as not to affect other elements or disconnected (may be in a floating state).

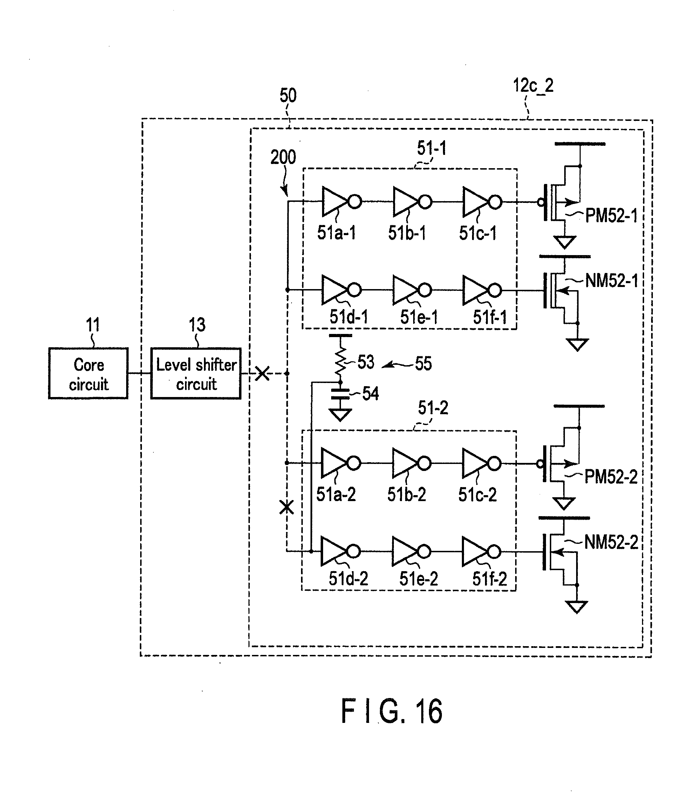

FIG. 16 is a block diagram showing the ESD protective element according to the second embodiment. Note that FIG. 16 does not illustrate the input circuit. FIG. 16 shows connection in a case where the ESD protective element 12c is used as the low voltage ESD protective element 12c_2.

As shown in FIG. 16, the low voltage ESD protective element 12c_2 includes the output change circuit 50 formed by rewiring the circuit elements of the output circuit 20 of the used IO cell 12a (unused IO cell 12b). For this reason, the low voltage ESD protective element 12c_2 includes the same semiconductor elements as in the used IO cell 12a (unused IO cell 12b). The semiconductor elements in the low voltage ESD protective element 12c_2 have the same arrangement as the semiconductor elements in the used IO cell 12a (unused IO cell 12b).

The low withstand voltage buffer circuit 51_2 includes low withstand voltage inverters 51a_2, 51b_2, 51c_2, 51d_2, 51e_2, and 51f_2. The low withstand voltage inverters 51d_2, 51e_2, and 51f_2 form an inverter chain.

The inverter chain constituted by the low withstand voltage inverters 51d_2, 51e_2, and 51f_2 is arranged between the RC delay circuit 55 and the gate of the low withstand voltage NMOS transistor NM52_2. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the low withstand voltage NMOS transistor NM52_2.

More specifically, the input terminal of the low withstand voltage inverter 51d_2 is electrically connected to the output terminal of the RC delay circuit 55, and the output terminal of the inverter 51d_2 is electrically connected to the input terminal of the low withstand voltage inverter 51e_2. The output terminal of the low withstand voltage inverter 51e_2 is electrically connected to the input terminal of the low withstand voltage inverter 51f_2. The output terminal of the low withstand voltage inverter 51f_2 is electrically connected to the gate of the low withstand voltage NMOS transistor NM52_2.

The source of the low withstand voltage NMOS transistor NM52_2 is electrically connected to the ground terminal, and the drain is electrically connected to the power supply terminal. In this example, the low withstand voltage NMOS transistor NM52_2 functions as a shunt transistor.

The RC delay circuit 55 is constituted by the series connected element of the resistor 53 and the capacitor 54. One terminal of the RC delay circuit 55 is electrically connected to the power supply terminal, and the other terminal is electrically connected to the ground terminal. More specifically, one terminal of the resistor 53 is electrically connected to the power supply terminal, and the other terminal is electrically connected to one terminal of the capacitor 54. The other terminal of the capacitor is electrically connected to the ground terminal.

The output terminal (the node between the other terminal of the resistor 53 and one terminal of the capacitor 54) of the RC delay circuit 55 is electrically connected to the gate of the low withstand voltage NMOS transistor NM52_2 via the inverter chain constituted by the low withstand voltage inverters 51d_2, 51e_2, and 51f_2.

Note that the inverter chain need not always be constituted by the three low withstand voltage inverters 51d_2, 51e_2, and 51f_2. Since the gate of the low withstand voltage NMOS transistor NM52_2 is at "L" level in a steady state, the inverter chain need only be constituted by an odd number of low withstand voltage inverters or logic gates equivalent to the inverters.

The low withstand voltage inverters 51a_2, 51b_2, and 51c_2 and the low withstand voltage PMOS transistor PM52_2 are dummy elements that do not particularly function. For this reason, the low withstand voltage inverters 51a_2, 51b_2, and 51c_2 and the low withstand voltage PMOS transistor PM52_2 can be either electrically connected so as not to affect other elements or disconnected (may be in a floating state).

When the ESD protective element 12c is used as the low voltage ESD protective element 12c_2, the high withstand voltage buffer circuit 51_1, the high withstand voltage PMOS transistor PM52_1, and the high withstand voltage NMOS transistor NM52_1 are dummy elements that do not particularly function. For this reason, the high withstand voltage inverters 51a_1, 51b_1, 51c_1, 51d_1, 51e_1, and 51f_1, the high withstand voltage PMOS transistor PM52_1, and the high withstand voltage NMOS transistor NM52_1 can be either electrically connected so as not to affect other elements or disconnected (may be in a floating state).

Modifications 1 to 5 of the first embodiment are also applicable to the high voltage ESD protective element 12c_1 and the low voltage ESD protective element 12c_2 shown in FIGS. 15 and 16.

### [Effects of Second Embodiment]

According to the second embodiment, each of the used IO cell 12a and the ESD protective element 12c has a circuit arrangement for a high voltage and that for a low voltage. When connection (rewiring) for a high voltage or a low voltage is done, the used IO cell 12a and the ESD protective element 12c can selectively use a withstand voltage for a high voltage or a low voltage.

### <Third Embodiment>

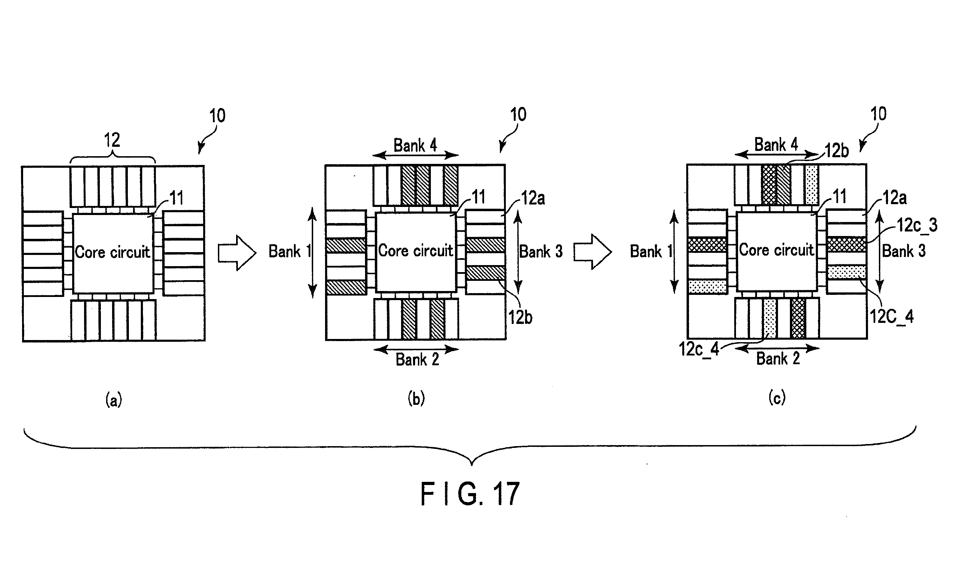

A semiconductor device according to the third embodiment will be described with reference to FIGS. 17, 18, 19, and 20. In the third embodiment, an IO cell region 12 includes a third power supply terminal other than a second power supply terminal that supplies power to an output circuit 20 and an input circuit 30. For this reason, ESD protection is necessary for the second power supply terminal and the third power supply terminal. Hence, ESD protective elements 12c using the power supply terminals are necessary and are selectively used as a second power supply ESD protective element 12c_3 that protects the second power supply terminal and a third power supply ESD protective element 12c_4 that protects the third power supply terminal. The third embodiment will be described below in detail.

Note that in the third embodiment, a description of the same points as in the first embodiment will be omitted, and differences will mainly be explained.

### [Arrangement according to Third Embodiment]

FIG. 17 is a view schematically showing a method of arranging an ESD protective element according to the third embodiment.

First, as shown in (a) of FIG. 17, the IO cell regions 12 are arranged on the periphery of a semiconductor chip 10. Each IO cell region 12 includes a plurality of cells (slots). Each cell includes various kinds of semiconductor elements so as to function as any of a used IO cell 12a, an unused IO cell 12b, and the ESD protective element 12c by rewiring.

Next, as shown in (b) of FIG. 17, each cell in the IO cell regions 12 is determined as the used IO cell 12a or the unused IO cell 12b. At this time, the IO cell regions 12 are divided into, for example, banks Bank1 to Bank4 on a power supply region basis. In the third embodiment, the second power supply terminal and the third power supply terminal are arranged in each bank Bank.

Then, as shown in (c) of FIG. 17, some of the unused IO cells 12b are changed to the ESD protective elements 12c by rewiring the upper wiring. Each ESD protective element 12c is selectively used as the second power supply ESD protective element 12c_3 that protects the second power supply terminal or the third power supply ESD protective element 12c_4 that protects the third power supply terminal. At this time, the wiring is rewired such that both a predetermined number of second power supply ESD protective elements 12c_3 and a predetermined number of third power supply ESD protective elements 12c_4 (here, one second power supply ESD protective element 12c_3 and one third power supply ESD protective element 12c_4) exist in each bank Bank.

A predetermined number of second power supply ESD protective elements 12c_3 and a predetermined number of third power supply ESD protective elements 12c_4 can thus be arranged in each bank Bank while reducing the unused IO cells 12b and reducing extra ESD protective elements 12c in the IO cell regions 12.

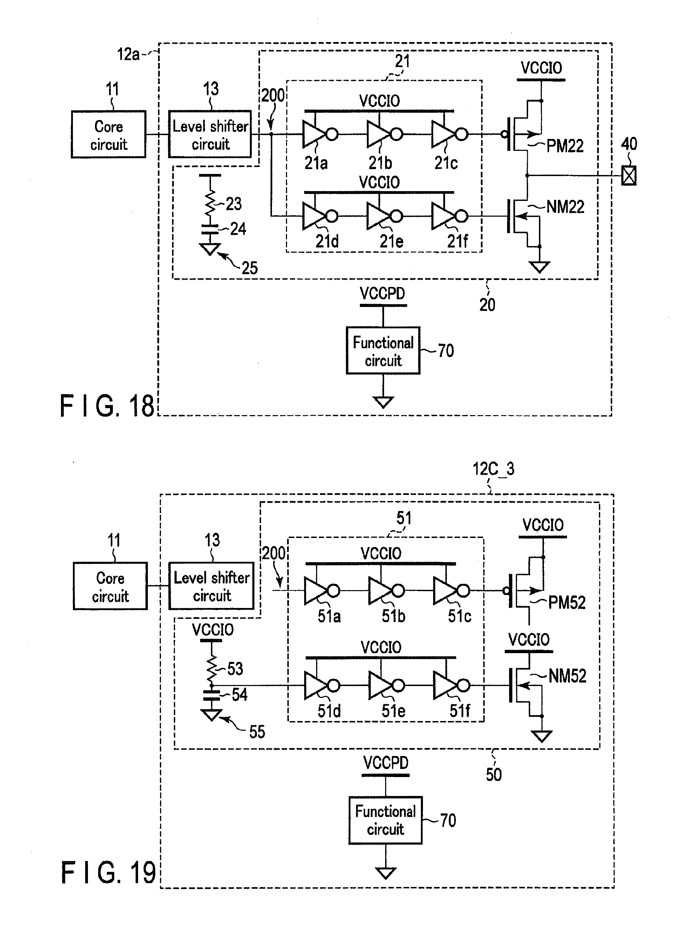

FIG. 18 is a block diagram showing a used IO cell according to the third embodiment. Note that the input circuit is not illustrated here.

As shown in FIG. 18, the used IO cell 12a includes the output circuit 20, a level shifter circuit 13, a functional circuit 70, a first power supply terminal (not shown) to which the same power supply as a core circuit 11 is supplied, a second power supply terminal VCCIO that supplies power to the output circuit 20, a third power supply terminal VCCPD that supplies power to the functional circuit 70, and a ground terminal.

The functional circuit 70 is a circuit other than the output circuit 20 (and an input circuit 30), and has various functions other than output and input in the used IO cell 12a. The functional circuit 70 is arranged between the third power supply terminal VCCPD and the ground terminal.

The output circuit 20 includes a power supply terminal to which a power supply voltage is applied, a ground terminal connected to ground, a buffer circuit 21, an RC delay circuit 25, a PMOS transistor PM22, and an NMOS transistor NM22.

The buffer circuit 21 includes inverters 21a, 21b, 21c, 21d, 21e, and 21f. The inverters 21a, 21b, and 21c form an inverter chain, and the inverters 21d, 21e, and 21f form another inverter chain. The inverters 21a, 21b, 21c, 21d, 21e, and 21f are electrically connected to the second power supply terminal VCCIO.

The source of the PMOS transistor PM22 is electrically connected to the second power supply terminal VCCIO, and the drain is electrically connected to an IO pad 40. The source of the NMOS transistor NM22 is electrically connected to the ground terminal, and the drain is electrically connected to the IO pad 40.

FIG. 19 is a block diagram showing the ESD protective element according to the third embodiment. FIG. 19 shows connection in a case where the ESD protective element 12c is used as the second power supply ESD protective element 12c_3.

As shown in FIG. 19, the second power supply ESD protective element 12c_3 includes an output change circuit 50 formed by rewiring the circuit elements of the output circuit 20 of the used IO cell 12a (unused IO cell 12b). For this reason, the second power supply ESD protective element 12c_3 includes the same semiconductor elements as in the used IO cell 12a (unused IO cell 12b). The semiconductor elements in the second power supply ESD protective element 12c_3 have the same arrangement as the semiconductor elements in the used IO cell 12a (unused IO cell 12b).

The second power supply ESD protective element 12c_3 includes the level shifter circuit 13, the output change circuit 50, the functional circuit 70, a power supply terminal (second power supply terminal VCCIO) connected by wiring to the second power supply terminals VCCIO of IO cells belonging to the same Bank, a power supply terminal (third power supply terminal VCCPD) connected by wiring to the third power supply terminals VCCPD of IO cells belonging to the same Bank, a ground terminal connected by wiring to the ground terminals of IO cells belonging to the same Bank, an RC delay circuit 55, a buffer circuit 51, a PMOS transistor PM52, and an NMOS transistor NM52.

The buffer circuit 51 includes inverters 51a, 51b, 51c, 51d, 51e, and 51f. The inverters 51d, 51e, and 51f form an inverter chain. The inverters 51d, 51e, and 51f are electrically connected to the second power supply terminal VCCIO.

The inverter chain formed from the inverters 51d, 51e, and 51f is arranged between the RC delay circuit 55 and the gate of the NMOS transistor NM52. The input terminal of this inverter chain is electrically connected to the output terminal (the node between the other terminal of a resistor 53 and one terminal of a capacitor 54) of the RC delay circuit 55, and the output terminal of the above inverter chain is electrically connected to the gate of the NMOS transistor NM52.

More specifically, the input terminal of the inverter 51d is electrically connected to the output terminal of the RC delay circuit 55, and the output terminal of the inverter 51d is electrically connected to the input terminal of the inverter 51e. The output terminal of the inverter 51e is electrically connected to the input terminal of the inverter 51f. The output terminal of the inverter 51f is electrically connected to the gate of the NMOS transistor NM52.

The source of the NMOS transistor NM52 is electrically connected to the ground terminal, and the drain is electrically connected to the second power supply terminal VCCIO. In this example, the NMOS transistor NM52 functions as a shunt transistor.

The output terminal (the node between the other terminal of the resistor 53 and one terminal of the capacitor 54) of the RC delay circuit 55 is electrically connected to the gate of the NMOS transistor NM52 via the inverter chain constituted by the inverters 51d, 51e, and 51f. The power supply terminal of the RC delay circuit 55 is electrically connected to the second power supply terminal VCCIO.

The inverters 51a, 51b, and 51c, the PMOS transistor PM52, and the functional circuit 70 are dummy elements that do not particularly function. For this reason, the inverters 51a, 51b, and 51c, the PMOS transistor PM52, and the functional circuit 70 can be either electrically connected so as not to affect other elements or disconnected (may be in a floating state).

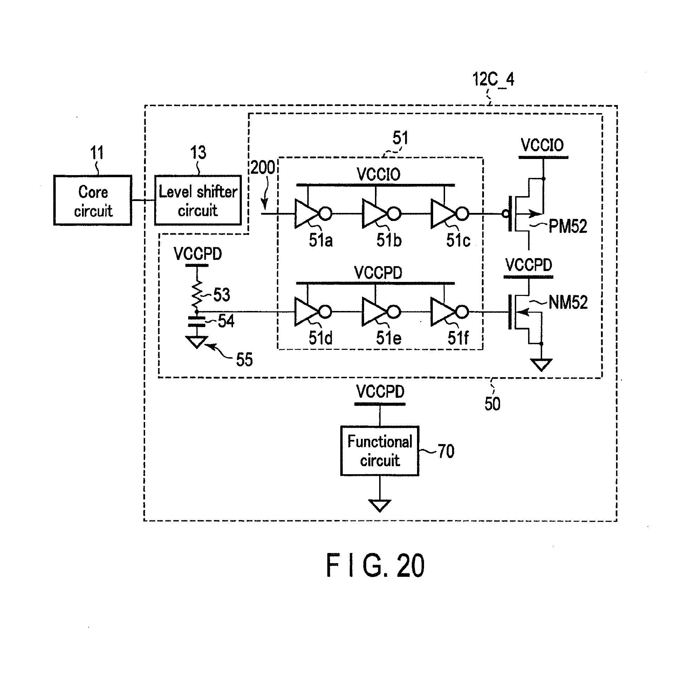

FIG. 20 is a block diagram showing the ESD protective element according to the third embodiment. FIG. 20 shows connection in a case where the ESD protective element 12c is used as the third power supply ESD protective element 12c_4.

As shown in FIG. 20, the third power supply ESD protective element 12c_4 includes the output change circuit 50 formed by rewiring the circuit elements of the output circuit 20 of the used IO cell 12a (unused IO cell 12b). For this reason, the third power supply ESD protective element 12c_4 includes the same semiconductor elements as in the used IO cell 12a (unused IO cell 12b). The semiconductor elements in the third power supply ESD protective element 12c_4 have the same arrangement as the semiconductor elements in the used 10 cell 12a (unused IO cell 12b).

The third power supply ESD protective element 12c_4 includes the level shifter circuit 13, the output change circuit 50, the functional circuit 70, a power supply terminal (second power supply terminal VCCIO) connected by wiring to the second power supply terminals VCCIO of IO cells belonging to the same Bank, a power supply terminal (third power supply terminal VCCPD) connected by wiring to the third power supply terminals VCCPD of IO cells belonging to the same Bank, a ground terminal connected by wiring to the ground terminals of IO cells belonging to the same Bank, the RC delay circuit 55, the buffer circuit 51, the PMOS transistor PM52, and the NMOS transistor NM52.

The buffer circuit 51 includes the inverters 51a, 51b, 51c, 51d, 51e, and 51f. The inverters 51d, 51e, and 51f form an inverter chain. The inverters 51d, 51e, and 51f are electrically connected to the third power supply terminal VCCPD.

The inverter chain constituted by the inverters 51d, 51e, and 51f is arranged between the RC delay circuit 55 and the gate of the NMOS transistor NM52. The input terminal of this inverter chain is electrically connected to the output terminal (the node between the other terminal of the resistor 53 and one terminal of the capacitor 54) of the RC delay circuit 55, and the output terminal of the above inverter chain is electrically connected to the gate of the NMOS transistor NM52.

More specifically, the input terminal of the inverter 51d is electrically connected to the output terminal of the RC delay circuit 55, and the output terminal of the inverter 51d is electrically connected to the input terminal of the inverter 51e. The output terminal of the inverter 51e is electrically connected to the input terminal of the inverter 51f. The output terminal of the inverter 51f is electrically connected to the gate of the NMOS transistor NM52.

The source of the NMOS transistor NM52 is electrically connected to the ground terminal, and the drain is electrically connected to the third power supply terminal VCCPD. In this example, the NMOS transistor NM52 functions as a shunt transistor.

The output terminal (the node between the other terminal of the resistor 53 and one terminal of the capacitor 54) of the RC delay circuit 55 is electrically connected to the gate of the NMOS transistor NM52 via the inverter chain formed from the inverters 51d, 51e, and 51f. The power supply terminal of the RC delay circuit 55 is electrically connected to the third power supply terminal VCCPD.

The inverters 51a, 51b, and 51c, the PMOS transistor PM52, and the functional circuit 70 are dummy elements that do not particularly function. For this reason, the inverters 51a, 51b, and 51c, the PMOS transistor PM52, and the functional circuit 70 can be either electrically connected so as not to affect other elements or disconnected (may be in a floating state).

Note that Modifications 1 to 5 of the first embodiment are also applicable to the ESD protective element according to the third embodiment. In the third power supply ESD protective element 12c_4, if the PMOS transistor PM52 functions as a shunt transistor, the gate is electrically connected to the output terminal of the inverter 51c, the source is electrically connected to the third power supply terminal VCCPD, and the drain is electrically connected to the ground terminal.

### [Effects of Third Embodiment]

According to the third embodiment, the IO cell region 12 includes the third power supply terminal VCCPD that supplies power to the functional circuit 70 as well as the second power supply terminal VCCIO that supplies power to the output circuit 20 and the input circuit 30. This makes it possible to use not only the second power supply terminal VCCIO but also the third power supply terminal VCCPD as the ESD protective element 12c. Hence, the ESD protective element 12c can be selectively used as the second power supply ESD protective element 12c_3 using the second power supply terminal or the third power supply ESD protective element 12c_4 using the third power supply terminal.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor device comprising:
a core circuit; and
a first IO cell and a second IO cell arranged on a periphery of the core circuit;
wherein each of the first IO cell and the second IO cell comprises:
a power supply terminal to which a power supply voltage is applied;
a ground terminal connected to ground;
an RC delay circuit including a resistor having one terminal connected to one of the power supply terminal and the ground terminal and a capacitor having one terminal connected to the other terminal of the resistor and the other terminal connected to the other of the power supply terminal and the ground terminal;
a P-type transistor; and
an N-type transistor,
in at least one of the first IO cell and the second IO cell, a connection terminal between the resistor and the capacitor is connected to a gate of at least one transistor of the P-type transistor and the N-type transistor,
when the at least one transistor is the P-type transistor, a source of the P-type transistor is connected to the first power supply terminal, and a drain is connected to the ground terminal, and
when the at least one transistor is the N-type transistor, the drain of the N-type transistor is connected to the first power supply terminal, and the source is connected to the ground terminal.

2. The device of claim 1, wherein each of the first IO cell and the second IO cell further comprises:
a first buffer having an output terminal connected to the gate of the P-type transistor; and
a second buffer having the output terminal connected to the gate of the N-type transistor,
each of the first buffer and the second buffer includes an inverter chain including inverters,
when the at least one transistor is the P-type transistor, the gate of the P-type transistor is connected to the connection terminal via the first buffer, and
when the at least one transistor is the N-type transistor, the gate of the N-type transistor is connected to the connection terminal via the second buffer.

3. The device of claim 1, wherein
when the at least one transistor is the P-type transistor, the N-type transistor is a dummy element not being involved in circuit operation, and
when the at least one transistor is the N-type transistor, the P-type transistor is a dummy element not being involved in circuit operation.

4. The device of claim 1, wherein one terminal of the resistor is connected to the first power supply terminal, and the other terminal of the capacitor is connected to the ground terminal.

5. The device of claim 1, wherein the other terminal of the capacitor is connected to the first power supply terminal, and one terminal of the resistor is connected to the ground terminal.

6. A semiconductor device comprising:
a core circuit; and
a first IO cell and a second IO cell arranged on a periphery of the core circuit;
wherein each of the first IO cell and the second IO cell comprises:
a power supply terminal to which a power supply voltage is applied;
a ground terminal connected to ground;
an RC delay circuit including a resistor having one terminal connected to one of the power supply terminal and the ground terminal and a capacitor having one terminal connected to the other terminal of the resistor and the other terminal connected to the other of the power supply terminal and the ground terminal;
a high withstand voltage P-type transistor;
a high withstand voltage N-type transistor;
a low withstand voltage P-type transistor having a lower withstand voltage than the high withstand voltage P-type transistor; and
a low withstand voltage N-type transistor having a lower withstand voltage than the high withstand voltage N-type transistor,
when at least one of the first IO cell and the second IO cell is used as a high withstand voltage type, a connection terminal between the resistor and the capacitor is connected to a gate of at least one transistor out of the high withstand voltage P-type transistor and the high withstand voltage N-type transistor,
when at least one of the first IO cell and the second IO cell is used as the high withstand voltage type, and the at least one transistor is the high withstand voltage P-type transistor, a source of the high withstand voltage P-type transistor is connected to the power supply terminal, and a drain is connected to the ground terminal,
when at least one of the first IO cell and the second IO cell is used as the high withstand voltage type, and the at least one transistor is the high withstand voltage N-type transistor, the drain of the high withstand voltage N-type transistor is connected to the power supply terminal, and the source is connected to the ground terminal,
when at least one of the first IO cell and the second IO cell is used as a low withstand voltage type, the connection terminal between the resistor and the capacitor is connected to the gate of at least one transistor out of the low withstand voltage P-type transistor and the low withstand voltage N-type transistor,
when at least one of the first IO cell and the second IO cell is used as the low withstand voltage type, and the at least one transistor is the low withstand voltage P-type transistor, the source of the low withstand voltage P-type transistor is connected to the power supply terminal, and the drain is connected to the ground terminal, and
when at least one of the first IO cell and the second 10 cell is used as the low withstand voltage type, and the at least one transistor is the low withstand voltage N-type transistor, the drain of the low withstand voltage N-type transistor is connected to the power supply terminal, and the source is connected to the ground terminal.

7. The device of claim 6, wherein each of the first IO cell and the second IO cell further comprises:
a first buffer having an output terminal connected to the gate of the high withstand voltage P-type transistor;
a second buffer having the output terminal connected to the gate of the high withstand voltage N-type transistor,
a third buffer having the output terminal connected to the gate of the low withstand voltage P-type transistor; and
a fourth buffer having the output terminal connected to the gate of the low withstand voltage N-type transistor,
each of the first buffer, the second buffer, the third buffer, and the fourth buffer includes an inverter chain including inverters,
when at least one of the first IO cell and the second IO cell is used as the high withstand voltage type, and the at least one transistor is the high withstand voltage P-type transistor, the gate of the high withstand P-type transistor is connected to the connection terminal via the first buffer,
when at least one of the first IO cell and the second IO cell is used as the high withstand voltage type, and the at least one transistor is the high withstand voltage N-type transistor, the gate of the high withstand N-type transistor is connected to the connection terminal via the second buffer,
when at least one of the first IO cell and the second IO cell is used as the low withstand voltage type, and the at least one transistor is the low withstand voltage P-type transistor, the gate of the low withstand P-type transistor is connected to the connection terminal via the third buffer, and
when at least one of the first IO cell and the second IO cell is used as the low withstand voltage type, and the at least one transistor is the low withstand voltage N-type transistor, the gate of the low withstand N-type transistor is connected to the connection terminal via the fourth buffer.

8. The device of claim 6, wherein
when at least one of the first IO cell and the second IO cell is used as the high withstand voltage type, and the at least one transistor is the high withstand voltage P-type transistor, the high withstand voltage N-type transistor, the low withstand voltage P-type transistor, and the low withstand voltage N-type transistor are dummy elements not being involved in circuit operation,
when at least one of the first IO cell and the second IO cell is used as the high withstand voltage type, and the at least one transistor is the high withstand voltage N-type transistor, the high withstand voltage P-type transistor, the low withstand voltage P-type transistor, and the low withstand voltage N-type transistor are dummy elements not being involved in circuit operation,
when at least one of the first IO cell and the second IO cell is used as the low withstand voltage type, and the at least one transistor is the low withstand voltage P-type transistor, the low withstand voltage N-type transistor, the high withstand voltage P-type transistor, and the high withstand voltage N-type transistor are dummy elements not being involved in circuit operation, and
when at least one of the first IO cell and the second IO cell is used as the low withstand voltage type, and the at least one transistor is the low withstand voltage N-type transistor, the low withstand voltage P-type transistor, the high withstand voltage P-type transistor, and the high withstand voltage N-type transistor are dummy elements not being involved in circuit operation.

9. The device of claim 6, wherein one terminal of the resistor is connected to the power supply terminal, and the other terminal of the capacitor is connected to the ground terminal.

10. The device of claim 6, wherein the other terminal of the capacitor is connected to the power supply terminal, and one terminal of the resistor is connected to the ground terminal.

11. A semiconductor device comprising:
a core circuit; and
a first IO cell and a second IO cell arranged on a periphery of the core circuit;
wherein each of the first IO cell and the second IO cell comprises:
a first power supply terminal to which a power supply voltage is applied;
a second power supply terminal to which a power supply voltage different from that of the first power supply terminal is applied;
a ground terminal connected to ground;
an RC delay circuit including a first terminal, second terminal, a resistor having one terminal connected to one of the first terminal and the second terminal and a capacitor having one terminal connected to the other terminal of the resistor and the other terminal connected to the other of the first terminal and the second terminal
a P-type transistor; and
an N-type transistor,
one of the first terminal and the second terminal is connected to one of the first power supply terminal and the second power supply terminal and the other of the first terminal and the second terminal is connected to the ground terminal,
in the first IO cell, one of the first terminal and the second terminal is connected to the first power supply terminal, a connection terminal between the resistor and the capacitor is connected to a gate of at least one transistor of the P-type transistor and the N-type transistor via the wiring layer,
in the first IO cell, when the at least one transistor is the P-type transistor, a source of the P-type transistor is connected to the first power supply terminal, and a drain is connected to the ground terminal,
in the first IO cell, when the at least one transistor is the N-type transistor, the drain of the N-type transistor is connected to the first power supply terminal, and the source is connected to the ground terminal.
in the second IO cell, one of the first terminal and the second terminal is connected to the second power supply terminal, the connection terminal between the resistor and the capacitor is connected to the gate of at least one transistor of the P-type transistor and the N-type transistor via the wiring layer,
in the second IO cell, when the at least one transistor is the P-type transistor, the source of the P-type transistor is connected to the second power supply terminal, and the drain is connected to the ground terminal,
in the second IO cell, when the at least one transistor is the N-type transistor, the drain of the N-type transistor is connected to the second power supply terminal, and the source is connected to the ground terminal.

12. The device of claim 11, wherein each of the first IO cell and the second IO cell further comprises:
a first buffer having an output terminal connected to the gate of the P-type transistor; and
a second buffer having the output terminal connected to the gate of the N-type transistor,
each of the first buffer and the second buffer includes an inverter chain including inverters,
in the first IO cell and the second IO cell, when the at least one transistor is the P-type transistor, the gate of the P-type transistor is connected to the connection terminal via the first buffer, and
in the first IO cell and the second IO cell, when the at least one transistor is the N-type transistor, the gate of the N-type transistor is connected to the connection terminal via the second buffer.

13. The device of claim 11, wherein
in the first IO cell and the second IO cell, when the at least one transistor is the P-type transistor, the N-type transistor is a dummy element not being involved in circuit operation, and
in the first IO cell and the second IO cell, when the at least one transistor is the N-type transistor, the P-type transistor is a dummy element not being involved in circuit operation.
